# EUROPEAN PATENT APPLICATION

(11) **EP 0 765 038 A2**
(43) Date of publication of application: **26.03.1997**
(21) Application number: 96305454.9
(22) Date of filing: 25.07.1996
(51) Int. Cl.: H03K 19/0948

(54) **Improvements relating to CMOS inverter design**

(30) Priority: 27.07.1995 US 1597
(71) Applicant: TEXAS INSTRUMENTS INCORPORATED, Dallas, Texas 75243 (US)
(72) Inventor: Sheffield, Bryan D., Allen, TX 75002 (US)
(74) Representative: Holt, Michael

(57) **Abstract**

A CMOS inverter structure (31) includes an input, an output and a current mirror (M3, M6) coupled to the input and the output.

## Description

### TECHNICAL FIELD OF THE INVENTION

The present invention relates generally to inverter design and, more particularly, to the design of CMOS inverters.

### BACKGROUND OF THE INVENTION

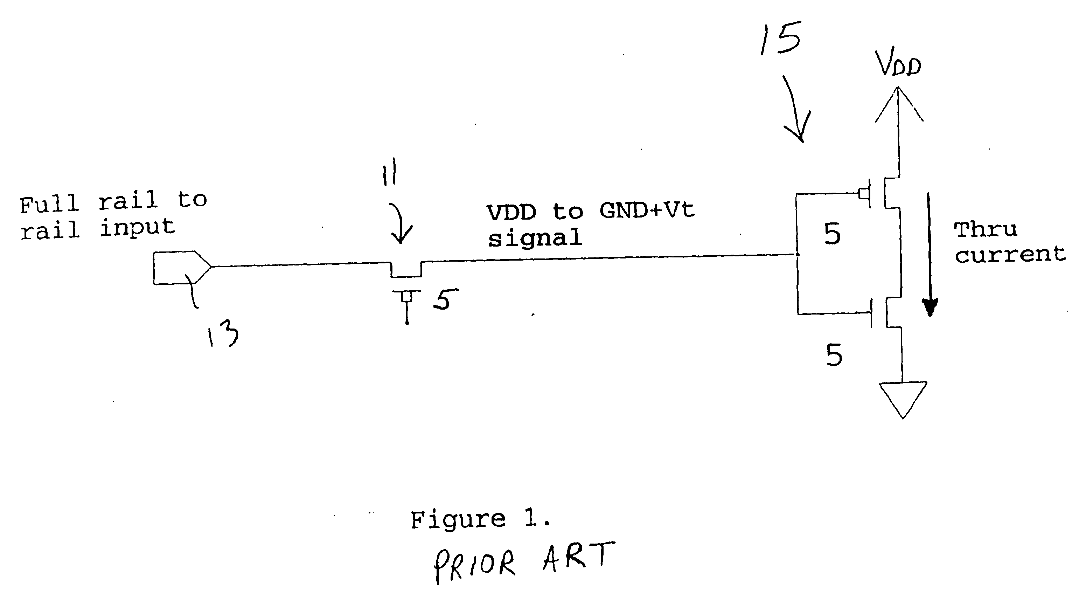

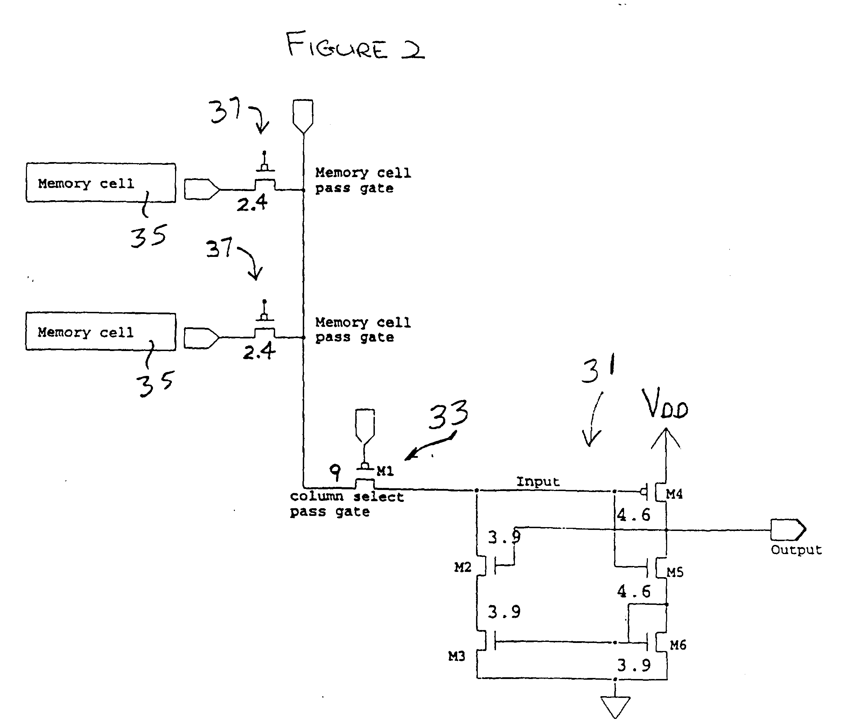

Figure 1 illustrates a p-channel pass gate 11 connecting a full rail-to-rail input 13 to the input of a CMOS inverter 15. Although the input voltage at 13 swings full rail-to-rail from V_{DD} to ground, it is impossible for the p-channel pass gate 11 to pass this full rail-to-rail voltage to the input of inverter 15. More specifically, the output of the pass gate 11 will only swing from V_{DD} to a voltage which is above grounc' by an amount equal to the p-channel threshold voltage Vₜ associated with the p-channel transistor 11. Thus, as shown in Figure 1, the output of pass gate 11 will swing only from V_{DD} to ground plus Vₜ. The ground plus Vₜ voltage will not turn the n-channel transistor of inverter 15 completely off, thereby resulting in a DC (or static) current flow through the n-channel transistor of inverter 15 as shown in Figure 1. Exemplary gate widths of the various transistors in Figure 1 are shown therein, and all of the exemplary transistors disclosed herein will be assumed for purposes of explanation to have a 0.6 micron gate length.

The aforementioned DC current disadvantageously results in undesirable static power dissipation in inverter 15.

It is therefore desirable to provide a CMOS inverter design which overcomes the problems associated with Figure 1.

The present invention provides a CMOS inverter design which, in response to an input voltage that swings as illustrated in Figure 1, outputs a full rail-to-rail voltage without static current leakage.

### BRIEF DESCRIPTION OF THE DRAWINGS

Figure 1 illustrates the static current that flows through an inverter whose input is driven by a p-channel pass gate.

Figure 2 illustrates an inverter design according to the present invention which avoids the static current problem of Figure 1.

Figure 3 illustrates an inverter for use at the output of the inverter of Figure 2.

### DETAILED DESCRIPTION

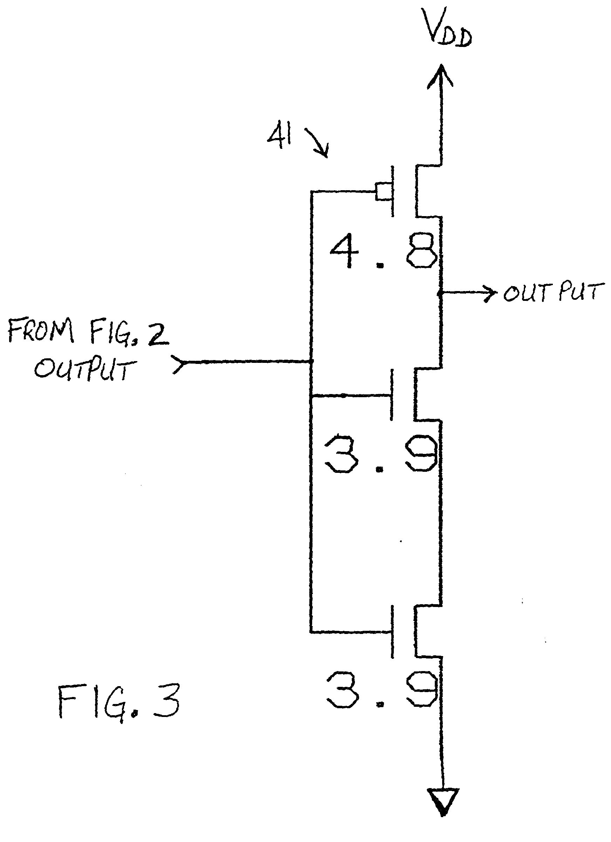

Figure 2 illustrates an exemplary inverter 31 according to the present invention. Exemplary gate widths of the Figure 2 transistors are shown therein. In the example of Figure 2, the inverter 31 receives its input from a column select pass gate 33 of a memory structure. The memory structure includes memory cells 35 and their respective pass gates 37. The combination of pass gates 37 and 33 thus provide the input of inverter 31 with an input voltage that does not fully swing rail-to-rail, as described above with respect to Figure 1. The inverter 31 takes the output of the p-channel pass gate 33 and outputs an inverted rail-to-rail signal.

The inverter 31 uses a current mirror including transistors M3 and M6, and this current mirror is connected between ground and the source of the n-channel transistor M5. The output of the current mirror is coupled to the input of inverter 31 via n-channel transistor M2. So, as any leakage current flows through the transistor M5, the same (or amplified) current is mirrored to the input of the inverter 31, thus pulling the inverter input down to ground.

When the input node of the inverter 31 is driven low, i.e. to a p-channel Vₜ above ground, the inverter output goes high, turning on transistor M2, thus allowing current through transistor M6 to be mirrored through transistor M3, pulling the inverter input lower until all current through transistors M5 and M6 is eliminated.

As the inverter input begins to pull high, the output starts going low, thus starting to turn off M2. This increases the resistance of the channel on M2, thus allowing the inverter input to be pulled higher, whereby the relatively weak p-channel transistor combination of transistors 37 and 33 can pull up the input node of inverter 31. Once the input node is pulled up to V_{DD}, the inverter output is at ground which turns off transistor M2, thus removing the input path to ground. The output of inverter 31, when going low, drops rapidly to one n-channel Vₜ from ground (which is typically smaller in magnitude than a p-channel Vₜ), and then eventually pulls all the way to ground.

The inverter design at 31 of Figure 2 therefore overcomes the problems discussed above with respect to Figure 1.

Figure 3 illustrates at 41 an exemplary inverter design for use at the output of the Figure 2 inverter 31. The pull down function in inverter 41 is realized by connecting two n-channel transistors in series, which, due to body effect, increases the effective threshold voltage Vₜ of the pull down function. The more that the Vₜ of the pull down function of inverter 41 exceeds the Vₜ of transistor M6 (Figure 2), the faster the pull down function of inverter 41 will shut off, thus advantageously reducing the amount of AC current (dynamic switching current) through inverter 41.

Although an exemplary embodiment of the present invention is described above, this description does not limit the scope of the invention, which can be practiced in a variety of embodiments.

## Claims

1. A CMOS inverter structure, comprising:
an input;
an output; and
a current mirror coupled to said input and said output.

2. The structure of Claim 1, including an n-channel transistor connected between said input and said current mirror.

3. The structure of Claim 2, wherein said n-channel transistor has a gate connected to said output.

4. The structure of Claim 1, including an n-channel transistor connected between said output and said current mirror.

5. The structure of Claim 4, wherein said n-channel transistor has a gate connected to said input.

6. The structure of Claim 1, including a first n-channel transistor connected between said input and said current mirror, and a second n-channel transistor connected between said output and said current mirror.

7. The structure of Claim 6, wherein said first n-channel transistor has a gate connected to said output and said second n-channel transistor has a gate connected to said input.

8. The structure of Claim 1, wherein said current mirror includes an n-channel transistor coupled to said output.

9. The structure of Claim 8, wherein said n-channel transistor has a gate and a drain that are connected to one another and coupled to said output.

10. The structure of Claim 1, wherein said current mirror includes an n-channel transistor coupled to said input.

11. The structure of Claim 1, wherein said current mirror includes a first n-channel transistor coupled to said output, and a second n-channel transistor coupled to said input.

12. The structure of Claim 11, wherein said first and second n-channel transistors have gates that are connected to one another.

13. The structure of Claim 12, wherein said first and second n-channel transistors have sources that are connected to one another.

14. The structure of Claim 13, wherein said first n-channel transistor has a drain that is connected to said gate thereof and coupled to said output.

15. The structure of Claim 12, wherein said first n-channel transistor has a drain that is connected to said gate thereof and coupled to said output.

16. The structure of Claim 11, wherein said first n-channel transistor has a drain that is connected to said gate thereof and is coupled to said output.

17. The structure of Claim 11, including a third n-channel transistor connected between said output and said first n-channel transistor, and a fourth n-channel transistor connected between input and said second n-channel transistor.

18. A CMOS circuit, comprising:
an inverter circuit including an input, an output and
a current mirror coupled to said input and said output; and
a p-channel transistor connected to said input.

19. The circuit of Claim 18, wherein said inverter circuit includes a first n-channel transistor connected between said input and said current mirror, and a second n-channel transistor connected between said output and said current mirror.

20. The circuit of Claim 19, wherein said first n-channel transistor has a gate connected to said output and said second n-channel transistor has a gate connected to said input.
